# DEMANDE DE BREVET EUROPEEN

(11) **EP 0 533 583 A1**
(43) Date de publication de la demande: **24.03.1993**
(21) Numéro de dépôt: 92402575.2
(22) Date de dépôt: 18.09.1992
(51) Int. Cl.: G06F 15/60

(54) **Procédé pour concevoir des circuits intégrés contrôleurs de protocole et système pour sa mise en oeuvre**

(30) Priorité: 20.09.1991 FR 9111630
(71) Demandeur: SGS-THOMSON MICROELECTRONICS S.A., F-94250 Gentilly (FR)
(72) Inventeur: Le Van Suu, Maurice c/o SGS THOMSON, F-94250 Gentilly (FR)
(74) Mandataire: Schmit, Christian Norbert Marie

(57) **Abrégé**

Procédé pour concevoir des circuits intégrés contrôleurs de protocole implémentant chacun un ensemble de fonctions prédéterminées de base architecturée, notamment des fonctions de gestion d'un protocole de communication d'informations au sein d'un véhicule automobile.

Le procédé comprend pour chaque circuit, une étape initiale de description synthétique de circuit selon des fonctions prédéterminées à l'aide d'un très haut niveau de description (VHDL), suivie d'une étape de synthèse et de compilation pour d'une part traiter des données de description issues de ladite étape de description synthétique et d'autre part intégrer des cellules correspondant à des fonctions communes prédéterminées, lesdites cellules étant préalablement stockées dans au moins une bibliothèque de cellules (4), et pour générer des informations de simulation qui sont ensuite traitées au cours d'une étape de routage synthétique pour générer une topographie (S) optimisée du circuit à concevoir.

Utilisation pour la conception de circuits dédiés à la communication et au traitement d'informations au sein de véhicules automobiles.

## Description

La présente invention concerne un procédé pour concevoir des circuits intégrés contrôleurs de protocole.

Elle vise également un système pour sa mise en oeuvre.

La conception de nouveaux systèmes de communication au sein des véhicules automobiles a impliqué pour les équipementiers de prévoir des circuits capables de gérer via un bus de communications multiplexé un ensemble de traitements d'interfaces tels que : des capteurs et des actionneurs, etc... équipant ces véhicules. Par véhicule automobile, on entend tout type de véhicule et notamment les voitures particulières, les camions, autobus et autocars. De tels circuits doivent généralement intégrer diverses fonctions dont le nombre et la complexité peuvent varier au gré des options et du niveau d'équipement de chaque gamme de véhicule. La conception de chaque circuit est actuellement conduite en mettant en oeuvre des outils de conception complexes, ce qui induit à chaque fois des coûts et des délais considérables, ces investissements matériels et humains étant en pratique difficilement transposables d'un circuit à un autre.

Le but de la présente invention est de remédier à ces inconvénients en proposant un procédé architecturé et modulaire pour concevoir des circuits intégrés contrôleurs de protocole implémentant chacun un ensemble de fonctions prédéterminées de base architecturée, notamment des fonctions de gestion d'un protocole de communication d'informations et des fonctions de traitement d'interfaces via un bus multiplexé, au sein d'un véhicule automobile.

Suivant l'invention le procédé comprend pour chaque circuit, une étape initiale de description synthétique du circuit architecturé selon lesdites fonctions prédéterminées à l'aide d'un très haut niveau de description, suivie d'une étape de synthèse et de compilation pour d'une part, traiter des données de description issues de ladite étape de description synthétique et d'autre part intégrer des fonctions de base et des fonctions spécifiques prédéterminées, lesdites fonctions étant préalablement stockées dans au moins une bibliothèque de fonctions.

Ainsi, avec le procédé selon l'invention, lors de la conception de chaque circuit, celles des fonctions à implémenter qui présentent un caractère commun à l'ensemble des circuits à concevoir pour un contexte applicatif donné ou sont spécifiques d'une ou plusieurs fonctions applicatives données, par exemple un système multiplexé de communication au sein d'un véhicule automobile, sont directement identifiées au niveau de la description architecturée et traduites en faisant appel à des cellules associées à ces fonctions communes ou spécifiques et stockées dans une bibliothèque de cellules. On obtient alors, pour la conception d'une famille de circuits contrôleurs de protocole distincts mais implémentant cependant des fonctions communes architecturées ou spécifiques, un gain considérable de temps et une réduction sensible des coûts de conception par rapport aux procédés de conception de l'art antérieur, puisque des blocs entiers de fonctions de base ou spécifiques sont structurés et isolés des fonctions applicatives et sont en outre traités préalablement et validés séparément ou par bloc structuré par traduction directe de cellules stockées dans une ou plusieurs bibliothèques consultées au cours de la mise en oeuvre du procédé selon l'invention. On entend par bloc structuré la combinaison d'un noyau et d'une mémoire de stockage qui peut être matérialisée par un microprocesseur ou un microcontrôleur.

L'invention a encore pour objet un procédé, caractérisé en ce qu'il comprend en outre une étape de génération des informations de simulation comportementale qui sont ensuite traitées au cours d'une étape de routage synthétique pour fournir une topographie optimisée du circuit à concevoir et d'une étape de simulation de la réponse du circuit à des stimuli.

Suivant un autre aspect de l'invention, le système pour concevoir des circuits intégrés implémentant un ensemble de fonctions structurées prédéterminées, notamment des fonctions de gestion d'un protocole de communication multiplexé d'informations au sein d'un véhicule automobile ou équivalent, mettant en oeuvre le procédé selon l'invention, est caractérisé en ce qu'il comprend des moyens pour décrire selon un très haut niveau de description (VHDL) un circuit à concevoir, des moyens pour simuler le comportement de ce circuit à partir des informations de description synthétique délivrées par lesdits moyens de description et de cellules extraites d'au moins une bibliothèque reliée auxdits moyens de simulation comportementale, et des moyens de routage pour générer, à partir de résultats de simulation générés par les moyens de simulation comportementale, une topographie optimisée du circuit à concevoir.

D'autres particularités et avantages de l'invention apparaîtront encore dans la description ci-après. Aux dessins annexés donnés à titre d'exemples non limitatifs :
- la figure 1 est un schéma synoptique illustrant les étapes essentielles du procédé selon l'invention ;
- la figure 2 est un schéma symbolisant l'organisation structurée et architecturée de la mise en oeuvre du procédé selon l'invention pour le traitement d'un protocole de communication ;
- la figure 3 est un schéma synoptique illustrant un exemple simplifié de configuration d'un système de communication multiplexée intégrant des circuits conçus avec le procédé selon l'invention.

On va maintenant décrire une forme préférée de mise en oeuvre du procédé selon l'invention en même temps que le système pour sa mise en oeuvre.

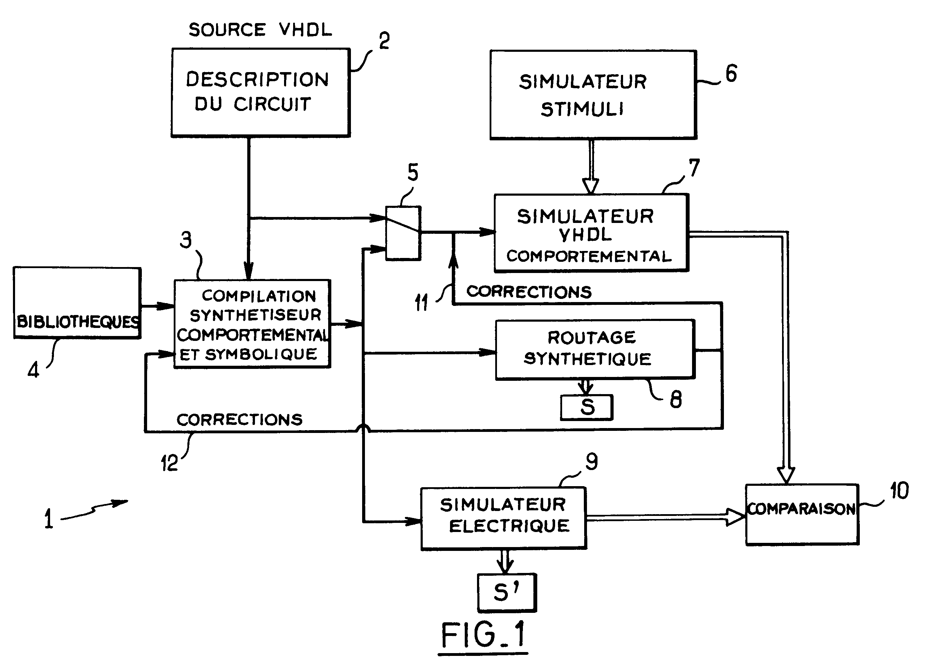

Le procédé selon l'invention met en oeuvre plusieurs séquences de simulation qui interagissent et conduisent finalement à la fourniture d'un schéma définitif structuré et optimisé et dont les interactions sont représentées dans le synoptique 1 de la figure 1, qui illustre une forme de réalisation d'un système pour la mise en oeuvre du procédé selon l'invention.

A l'origine, un cahier des charges ou de spécification énonçant l'ensemble des fonctions à réaliser par un circuit à concevoir, est décrit (2) selon un mode connu de description appelé VHDL (Very High Description Level : Très Haut Niveau de Description) ou en faisant appel à un autre langage de description à haut niveau. La description ainsi obtenue est entrée dans un synthétiseur comportemental 3 qui fait appel à des bibliothèques 4 contenant des cellules ou blocs spécifiques connues par l'homme de métier sous l'appellation de "megacells", et qui génère un ensemble de données qui sont traitées au cours d'une phase de routage et de placement 8 qui génère finalement, à l'issue de plusieurs étapes itératives d'optimisation, un schéma S symbolique global qui permet la fabrication du circuit intégré selon une technologie choisie. Les bibliothèques 4 emmagasinent également des fonctions comme il sera indiqué ci-après. La phase de routage génère également des informations de correction automatique qui sont introduites d'une part (12), dans le synthétiseur comportemental 3, et d'autre part (11), dans un simulateur VHDL- 7 qui est alimenté en données soit par le module de description du circuit 2, soit par le synthétiseur comportemental 3, le choix de l'origine des données entrées dans le simulateur VHDL étant représenté de façon imagée par une fonction de commutation 5. En outre, les données de simulation issues du synthétiseur comportemental 3 sont fournies à un simulateur électrique 9 qui génère en retour un schéma électrique S′ et des résultats de simulation électrique qui sont comparées (9) à des fins de vérification aux résultats de simulation délivrées par le simulateur VHDL (on rappelle que VHDL signifie : "très haut niveau de description"), qui traite des données issues du synthétiseur comportemental 3, et d'un simulateur synthétiseur du montage à des stimuli électriques 6.

Le procédé qui vient d'être décrit est avantageusement appliqué à la conception de circuits intégrés destinés à gérer des informations, - données et commandes notamment -, selon un protocole de communication multiplexé connu, tel que le protocole MUX/VAN (Multiplexage/"Véhicule Area Network").

A titre d'exemple, une trame émise selon le protocole MUX/VAN par un circuit de type maître comprend:
- un début de trame ou préambule
- un champ d'identification
- un champ de commande
- un champ de données
- un champ de vérification de données dans la trame
- une fin de données
- un champ d'acquittement
- un champ de fin de trame
- un champ d'espacement inter-trame.

Une trame typique émise par un circuit de type "maître vers esclave" esclave comprend l'ensemble des champs précités à l'exception du champ de données.

A titre d'exemple, un circuit destiné à un environnement MUX/VAN peut intégrer les fonctions suivantes :
- initialisation et reconfiguration automatique
- diagnostic de circuit
- communication/contrôleur de protocole
- test de trame et de champ
- synchronisation d'horloge locale ou à distance
- encodage/décodage
- encapsulation/décapsulation de données
- veille d'alimentation
- filtrage/acceptance
- mode de secours (échantillonnage et choix automatique des entrées les plus favorables)
- mémoire registre ou RAM.

Un tel circuit peut être implémenté pour gérer au sein d'un véhicule des applications aussi variées que des essuie-vitre, des manettes, ou un hayon et bien d'autres encore.

Avec le procédé selon l'invention, on peut distinguer une'première phase de spécification de conception indépendante de toute technologie et mettant en oeuvre une approche de type VHDL (Very High Description Level: Très Haut Niveau de Description) et faisant appel à des fonctions, des performances, des vecteurs et à une bibliothèque de conception, et une seconde phase de partition et de synthèse qui est elle intrinsèquement dépendante du type de technologie employé et fait appel à un ensemble de compilateurs de conception associés respectivement à chaque type de technologie accessible et à des bibliothèques de technologie.

L'ensemble des bibliothèques de conception et de technologies a été regroupé, sur la figure 1, sous la même référence : bibliothèques 4.

On peut aussi considérer que la synthèse d'un circuit peut également être décomposée en une première phase de traduction suivie d'une phase d'optimisation. Dans la première phase conduite en mode de description VHDL, les fonctions à intégrer sont exprimées en termes d'un ensemble de fonctions logiques qui sont elles-mêmes traduites sous la forme d'une logique intégrée de nature générique et qui constitue une représentation logique desdites fonctions. Dans la seconde phase, le compilateur de conception réalise l'optimisation de la conception à la fois en termes de rapidité et de surface de silicium en faisant bien sûr appel aux bibliothèques de composants associées à la technologie choisie.

Lors d'une séquence de compilation, une opération d'optimisation est effectuée au niveau logique, dans laquelle le circuit est représenté sous la forme d'équations écrites en language évolué, par exemple, PASCAL ou FORTRAN, à partir d'une description fonctionnelle (VHDL), tandis qu'une autre opération d'optimisation est menée cette fois au niveau des portes logiques en faisant appel à une ou plusieurs bibliothèques de technologie. Ces deux opérations d'optimisation sont en pratique menées en parallèle et interagissent pour conduire finalement à un schéma architecturé et optimisé, éventuellement à des reports ou corrections.

Avec le procédé selon l'invention, la mise en oeuvre d'un circuit contrôleur de protocole MUX/VAN est implémentée selon l'organisation suivante :
- un noyau du protocole, qui est commun à tous les circuits à concevoir et comprend des fonctions essentielles et minimales, notamment de test, de synchronisation, d'initialisation et d'encodage/décodage,
- des options, par exemple :
   - une mémoire d'émission, de profondeur (capacité) variable
   - une mémoire de réception, de profondeur (capacité) variable
   - une interface microprocesseur ou équivalent
   - une fonction DMA (Accès Direct Mémoire)
   - une fonction d'encodage/décodage
   - un oscillateur local
   - une fonction de diagnostic
   - une fonction de correction d'horloge,
   - une couche applicative, comprenant par exemple:
      - une interface d'entrée/sortie de technologie CMOS ou TTL
      - une interface de sortie de puissance
      - une interface analogique.

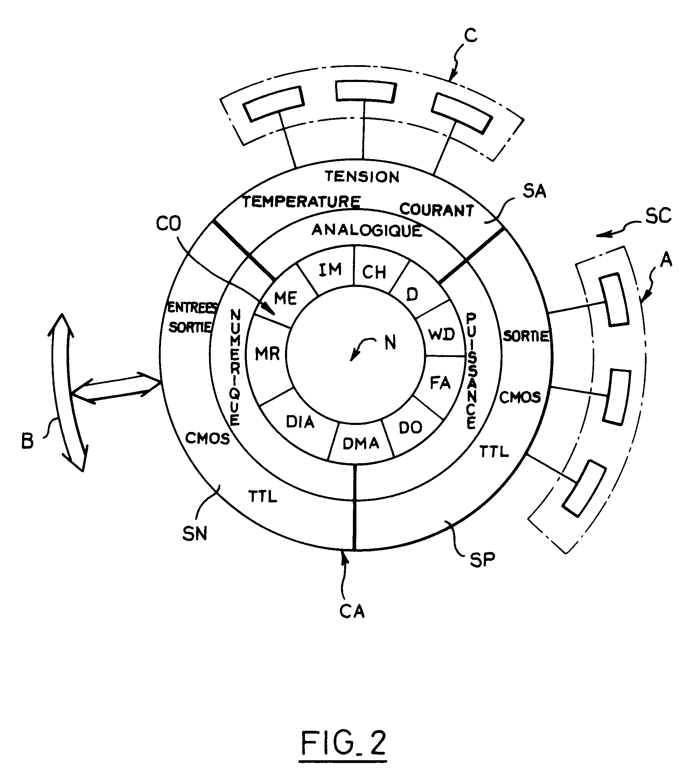

On peut, en référénce à la figure 2, représenter de manière symbolique l'organisation de la mise en oeuvre d'un circuit contrôleur de protocole selon l'invention par une structure concentrique SC un noyau N, une première couche d'options concentrique CO, entourée d'une seconde couche applicative CA qui comporte trois secteurs: Numérique SN (communication), Puissance SP (commande d'actionneurs) et Analogique SA (capteurs). Le secteur numérique SN, qui met en oeuvre des circuits logiques d'entrée/sortie de technologies variées, notamment CMOS ou TTL correspond à la gestion d'informations numériques transitant sur un bus de communication B qui est prévu pour être multiplexé. Le secteur SP qui intègre des circuits de puissance de sortie, également de technologie TTL ou CMOS ou de type "Boucle de Courant", correspond à la commande de puissance d'actionneurs A équipant un véhicule automobile, tandis que le secteur analogique correspond au traitement des données analogiques issues de capteurs physiques, tels que des capteurs de tension, de courant ou de température. La couche d'options CO intègre des fonctions aussi diverses que les fonctions suivantes :
- mémoire d'émission ME, interface microcontrôleur ou microprocesseur IM, correction d'horloge CH, détection D, "chien de garde" WD ou "watch-dog" selon la terminologie anglo-saxonne couramment utilisée, filtrage et acceptance FA, décodage optique DO, interface DMA, diagnostic DIA, mémoire de réception MR.

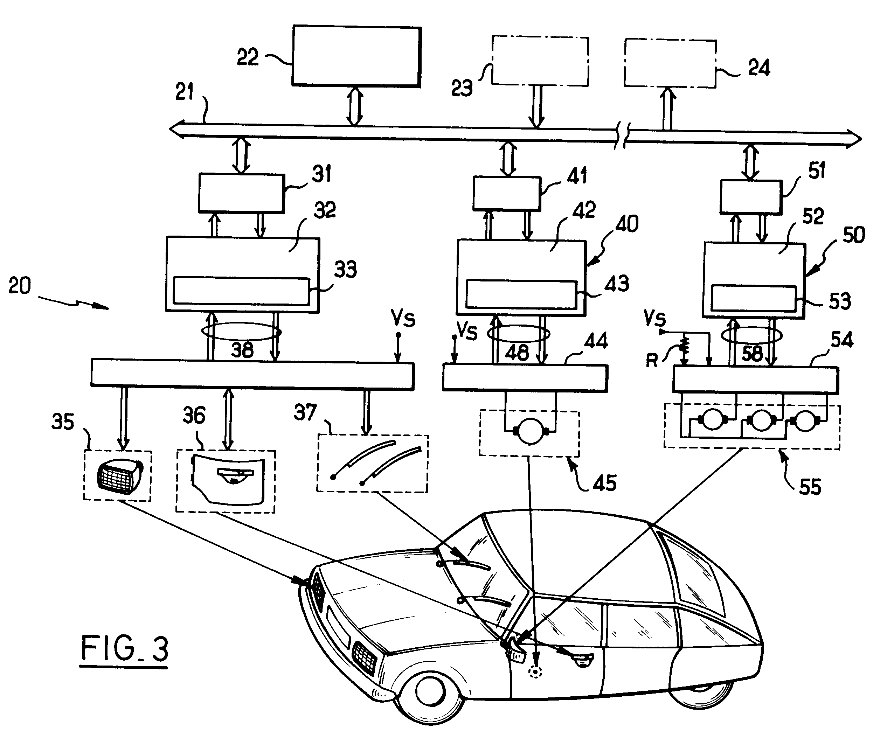

Des circuits conçus avec le procédé selon l'invention peuvent être avantageusement être inclus au sein d'un système global de communication 20 organisé autour d'un bus multiplexé 21 au sein d'un véhicule automobile 60, en référence à la figure 3.

Ainsi, à titre d'exemple non limitatif, des circuits intégrés dédiés 30, 40 et 50 communiquent par le bus 21 avec une unité centrale 22, des organes de commande 23 et des dispositifs de visualisation et d'affichage 24, via des circuits d'amplification, respectivement 31, 41 et 51. Chacun des circuits dédiés 30, 40, 50 comprend un noyau de protocole 32, 42, 52 constitué des fonctions communes à tous les circuits conçus avec le procédé selon l'invention, et une couche applicative 33, 43, 53 spécifique des applications particulières gérées par ledit circuit. Chaque circuit dédié 30, 40, 50 communique via un bus de commande respectif 38, 48, 58 avec un circuit d'interface d'application 34, 44, 54 qui pilote directement un ou plusieurs organes d'application. Ainsi, à titre d'exemple, le circuit d'interface 34 alimenté par une source de tension Vs peut piloter des organes d'éclairage 35, des dispositifs de verrouillage de porte 36 et des essuie-vitre 37. Le circuit d'interface 44 pilote un moteur M d'un lève-vitre 45, tandis que le circuit d'interface 54 contrôle à la fois l'alimentation d'une résistance de chauffage R d'un rétroviseur 55 à partir de la source de tension Vs et trois moteurs M1, M2 et M3 de positionnement de ce rétroviseur dans les trois axes.

Il faut noter qu'un système de communication tel que celui qui vient d'être décrit comporte en général un circuit Maître, par exemple un microcontrôleur ou un microprocesseur, un ou plusieurs circuits de type Maître/Esclave, et des circuits de type Esclave. Le procédé de conception selon l'invention peut être appliqué à la conception de ces trois familles de circuit.

Le procédé selon l'invention peut être avantageusement implémenté au sein d'un système de conception incluant notamment une ou plusieurs stations de travail sur lesquelles sont installés des logiciels de simulation électrique ou de type VHDL. Les schémas de routage et de placement générés sont utilisés suivant des techniques connues pour fabriquer à partir de pastilles de silicium les puces qui intégreront l'ensemble des fonctions désirées et plus particulièrement les fonctions de gestion du protocole MUX/VAN.

Des systèmes de conception mettant en oeuvre le procédé selon l'invention sont plus particulièrement destinés à être utilisés par des équipementiers pour la conception de circuits applicatifs, avec pour avantage essentiel de permettre une rationalisation des investissements de conception puisque les fonctions communes à l'ensemble des circuits applicatifs à concevoir, notamment les fonctions de gestion de protocole sont générées et traitées une fois pour toute grâce à la mise en oeuvre d'une approche descriptive de type VHDL. Les circuits intégrés applicatifs sont ensuite fabriquées selon des techniques connues de l'homme de métier selon une technologie préalablement choisie en fonctions de divers critères de performance et/ou de coût.

Il faut noter que les différents simulateurs, synthétiseurs et dispositifs de routage constituant un système de conception selon l'invention sont actuellement commercialement disponibles et intègrent des technologies connues de l'homme de métier.

Bien sûr, la présente invention n'est pas limitée aux exemples qui viennent d'être décrits et de nombreux aménagements peuvent être apportés à ces exemples sans sortir du cadre de l'invention.

Ainsi, le procédé selon l'invention peut concerner toute technologie de semi-conducteurs et n'est évidemment pas limité à la conception des seuls circuits précédemment décrits. En outre, il peut viser l'implémentation d'autres protocoles de communication que le protocole MUX/VAN, par exemple les protocoles CAN ou J1850.

De plus, la mise en oeuvre du procédé selon l'invention n'est pas limitée au seul cas de véhicules automobiles mais peut être étendue à tout type de véhicule dans lequel des problèmes complexes de communication doivent être résolus.

D'autres applications, telle que la domotique par exemple, sont susceptibles de mettre en oeuvre des circuits développés selon le procédé de l'invention.

## Revendications

1. Procédé pour concevoir une famille de circuits intégrés contrôleurs de protocole (30, 40, 50) utilisés dans des applications spécifiques implémentant chacun un ensemble de fonctions prédéterminées, notamment des fonctions de gestion d'un protocole de communication d'informations et des fonctions de traitement de ces informations (21), caractérisé en ce qu'il comprend pour chaque circuit (30, 40, 50), une étape initiale de description synthétique du circuit architecturé selon lesdites fonctions prédéterminées à l'aide d'un très haut niveau de description (2), suivie d'une étape de synthèse et de compilation pour d'une part, traiter des données de description issues de ladite étape de description synthétique et d'autre part intégrer des fonctions de base et des fonctions spécifiques prédéterminées, lesdites fonctions étant préalablement stockées dans au moins une bibliothèque de fonctions.

2. Procédé selon la revendication 1, caractérisé en ce qu'il comprend en outre une étape de génération des informations de simulation comportementale qui sont ensuite traitées au cours d'une étape de routage synthétique pour fournir une topographie optimisée (S) du circuit à concevoir (30, 40, 50) et d'une étape de simulation de la réponse du circuit à des stimuli.

3. Procédé selon la revendication 2, caractérisé en ce qu'il comprend en outre une étape de simulation électrique du circuit pour traiter des données issues de l'étape de compilation de la synthèse et générer des résultats de simulation électrique qui sont ensuite comparés, au cours d'une étape de comparaison, aux résultats de l'étape de simulation VHDL.

4. Procédé selon la revendication 3, caractérisé en ce que l'étape de routage comprend une suite d'étapes d'optimisation générant des informations de correction (12, 11) qui sont traitées pendant les étapes de compilation de la synthèse et de simulation VHDL (7).

5. Procédé selon l'une des revendications précédentes, caractérisé en ce que les étapes de description synthétique et de compilation de la synthèse structurent les fonctions à implémenter par le circuit à concevoir en :
- un noyau (N) comportant des fonctions de base, notamment des fonctions nécessaires à la gestion d'un protocole de communication,
- une première couche (CO) groupant des fonctions optionnelles (ME, IM, CH, D, WD, FA, DO, DMA, DIA, MR), et
- une seconde couche (CA) groupant des fonctions applicatives.

6. Procédé selon la revendication 6, caractérisé en ce que la seconde couche d'applications (CA) comprend un premier sous-ensemble d'applications numériques (SN), un second sous-ensemble d'applications analogiques (SA) et un troisième sous-ensemble d'applications de puissance (SP).

7. Système (1) pour concevoir des circuits intégrés (30, 40, 50) implémentant un ensemble de fonctions structurées prédéterminées, notamment des fonctions de gestion d'un protocole de communication d'informations et des fonctions de traitement de ces informations, mettant en oeuvre le procédé selon les revendications précédentes, caractérisé en ce qu'il comprend des moyens (2) pour décrire selon un très haut niveau de description (VHDL) un circuit à concevoir, des moyens (3) pour synthétiser ce circuit et pour en compiler la synthèse à partir des informations de description délivrées par lesdits moyens de description (2) et de cellules extraites d'au moins une bibliothèque (4) reliée auxdits moyens de simulation comportementale, et des moyens de routage (8) pour générer, à partir de résultats générés par les moyens de synthèse et de compilation (3), une topographie optimisée (S) du circuit à concevoir.

8. Système (1) selon la revendication 7, caractérisé en ce qu'il comprend en outre des moyens (9) pour simuler électriquement le circuit à concevoir à partir de données générées par les moyens de synthèse et de compilation (3) et pour générer un schéma électrique (S′)des résultats de simulation électrique.

9. Système (1) selon la revendication 8, caractérisé en ce qu'il comprend en outre des moyens (7) pour simuler à un très haut niveau de description (VHDL) le circuit à concevoir, à partir de données générées soit par les moyens de synthèse et de compilation (3), soit par les moyens de description (2), lesdits moyens de simulation VHDL (7) coopérant avec des moyens (6) pour simuler la réponse dudit circuit à des stimuli prédéterminés pour générer des résultats de simulation VHDL.

10. Système (1) selon la revendication 9, caractérisé en ce qu'il comprend en outre des moyens (10) pour comparer les résultats issus des moyens de simulation VHDL (7) aux résultats issus des moyens de simulation électrique (9).

11. Système (1) selon la revendication 10, caractérisé en ce que les moyens de routage (8) sont agencés pour générer des informations de correction à destination des moyens de synthèse et de compilation (3) et des moyens de simulation VHDL (7).

12. Système (1) selon l'une des revendications 7 à 11, caractérisé en ce que pour chaque circuit à concevoir, des cellules associées à des fonctions de gestion d'un protocole de communication sont mises en oeuvre par les moyens de synthèse et de compilation (3) pour générer un noyau de l'ensemble de fonctions réalisées par ledit circuit.

13. Système (1) selon la revendication 12, caractérisé en ce que le protocole de communication met en oeuvre un bus multiplexé (21).

14. Système (1) selon l'une quelconque des revendications 7 à 13, caractérisé en ce que lesdits circuits sont destinés à équiper des systèmes de communication au sein de véhicules automobiles (60) ou équivalent.
